# EUROPÄISCHE PATENTANMELDUNG

(11) **EP 2 631 389 A1**
(43) Veröffentlichungstag der Anmeldung: **28.08.2013**
(21) Anmeldenummer: 12001150.7
(22) Anmeldetag: 21.02.2012
(51) Int. Cl.: E04F 13/08, E04H 6/02, H01L 31/0392, H01L 31/048

(54) **Konstruktionselement, Herstellungsverfahren, Verwendung sowie Gebäude**

(71) Anmelder: Braunagel, Andreas, 88255 Baienfurt (DE); Braunagel, Georg, 88250 Weingarten (DE)
(72) Erfinder: Braunagel, Andreas, 88255 Baienfurt (DE); Braunagel, Georg, 88250 Weingarten (DE)
(74) Vertreter: Otten, Roth, Dobler & Partner

(57) **Zusammenfassung**

Vorgeschlagen wird ein Konstruktionselement (1) für Gebäudefassaden, insbesondere für die Außenwandverkleidung von Fassaden, das eine Grundplatte (2) aus einem Verbundmaterial umfasst, wobei an wenigstens einer Seite der Grundplatte eine Dünnschicht-Solarzelle (6) zur Erzeugung von elektrischer Energie angeordnet ist. Zudem werden ein Verfahren zu dessen Herstellung, eine Verwendung und ein Gebäude vorgeschlagen.

## Beschreibung

Die Erfindung betrifft ein Konstruktionselement für Gebäudefassaden, insbesondere für die Außenverkleidung von Fassaden, ein Verfahren zu dessen Herstellung, ein Gebäude sowie die Verwendung eines Konstruktionselementes.

Im Innen- und Außenbereich an Gebäuden werden aus dem Stand der Technik bekannte Verbundplatten eingesetzt. Es handelt sich dabei um Platten, die aus einem Verbundwerkstoff bzw. Kompositwerkstoff bestehen und beispielsweise als Verkleidungselemente an Fassaden, Decken, Balkonen, Türen, Dächern oder dergleichen eingesetzt werden. Da derartige Verbundplatten im Wesentlichen beliebig gestaltet werden können, werden diese unter anderem auch als dekorative Elemente verwendet.

Aufgabe der Erfindung ist es, ein verbessertes Konstruktionselement vorzuschlagen, das eine Kostenersparnis beim Bauen von Gebäuden mit energieeffizienter Bauweise ermöglicht.

Die Aufgabe wird, ausgehend von einem Konstruktionselement, einem Verfahren zu dessen Herstellung einem Gebäude sowie einer Verwendung eines solchen Konstruktionselements durch die Merkmale des Anspruchs 1 sowie durch die kennzeichnenden Merkmale der Ansprüche 8, 12 und 14 gelöst.

Durch die in den abhängigen Ansprüchen genannten Maßnahmen sind vorteilhafte Ausführungen und Weiterbildungen der Erfindung möglich.

Dementsprechend umfasst ein erfindungsgemäßes Konstruktionselement für Gebäudefassaden, insbesondere für die Außenwandverkleidung von Fassaden eine Grundplatte aus einem Verbundmaterial, wobei an wenigstens einer Seite der Grundplatte eine Dünnschicht-Solarzelle zur Erzeugung von elektrischer Energie angeordnet ist. Die Erfindung ermöglicht somit in vorteilhafter weise, dass die zur Verkleidung verwendeten Konstruktionselemente zusätzlich zur Stromversorgung und Energiegewinnung verwendet werden können. Gerade im Zusammenhang mit Gebäudefassaden stehen mitunter große Flächen zur Verfügung, die meist in ihrer Funktionalität jedoch ungenutzt bleiben. Zwar ist teilweise bekannt, Solarzellen nicht nur auf Dächern, sondern auch an Gebäudefassaden anzubringen, allerdings kommen für eine derartige Anwendung in der Regel Solarzellen zum Einsatz, deren Halbleitermaterial aus einem Bulkmaterial besteht, und die Solarzellen dementsprechend eine beachtliche Dicke von mitunter mehreren Zentimetern aufweisen. Derartige Solarzellen produzieren zum einen eine große Wärme und müssen außerdem mit aufwendigen Befestigungskonstruktionen an einer Gebäudefassade befestigt werden. Eine Reihe von Bedingungen müssen bei der Anbringung derartiger Dickschichtsolarzellen beachtet werden, beispielsweise, dass die Abwärme bei der Stromerzeugung möglichst effizient abgeführt wird. Dies bedeutet regelmäßig, dass die Solarzellen nicht unmittelbar in Kontakt zur Gebäudewand stehen dürfen. Des Weiteren ist grundsätzlich zu beachten, dass die Stabilität der Anbringung ausreicht, dass solche Dickschichtsolarzellen nicht durch Luftströmungen / wind abgerissen werden.

Zudem wurden unterdessen Dünnschichtsolarzellen bzw. Solarfolien entwickelt, welche wesentlich dünner ausgebildet sind als Solarzellen, die ein entsprechendes Halbleiter-Bulkmaterial umfassen. Derartige Solarfolien werden bislang jedoch ausschließlich auf Bedachungskonstruktionen angebracht, insbesondere bei Flachdächern, oder auf Glasfenster geklebt. Gerade bei Flachdachkonstruktionen sind die Trägermaterialien im Allgemeinen ebenfalls mehrere Zentimeter dick.

Dadurch, dass die Erfindung in vorteilhafter Weise eine Verbundplatte als Trägermaterial vorsieht, wird zum einen eine ausreichende Wärmeabfuhr für die Dünnschichtsolarzelle ermöglicht, zum andern aber auch ein flexibler Einsatz. Die Verbundplatte kann als Konstruktionselement verbaut werden, ohne dass eine schwere und aufwendige Befestigungsvorrichtung erforderlich wäre. Das entsprechende Konstruktionselement kann sich insbesondere auch besonders gut in fast alle Arten einer Fassadenverkleidung eingliedern. In der Regel kann die Fassade beispielsweise aus einer Vielzahl derartiger Konstruktionselemente zusammengesetzt sein. Daher ist es möglich, individuell auszuwählen, welche Konstruktionselemente zusätzlich mit einer derartigen Solarfolie ausgestattet werden. Gegebenenfalls können auch alle Konstruktionselemente eine derartige Solarfolie aufweisen. Somit kann für die Energiegewinnung ein wesentlicher Beitrag geleistet werden, da bislang ungenutzte Fassadenfläche nutzbar gemacht wird.

Insbesondere wird eine energieeffiziente Bauweise ermöglicht, da Dünnschicht-Solarzellen eingesetzt werden und zudem neben der üblicherweise mit Solarzellen versehenen Dachfläche auch z. B. die Fassadenfläche für die Energiegewinnung genutzt werden kann. Somit können Energiekosten eingespart werden. Da derartige Dünnschichtsolarzellen vergleichsweise günstig sind, wird ein zusätzlicher Kostenvorteil ermöglicht.

Die erfindungsgemäßen Konstruktionselemente ermöglichen darüber hinaus einen besonders einfachen Austausch, da sie meistens kein hohes Gewicht aufweisen und zudem auch in einfacher Weise montiert werden können. Der flexible Einsatz wird bei einem erfindungsgemäßen Konstruktionselement noch dadurch verstärkt, dass durch die Wahl des geeigneten Verbundmaterials Fassadenelemente für die verschiedensten Arten von Gebäuden an den verschiedensten Einsatzorten gefunden werden können. Die Verbundmaterialien haben in der Regel eine besonders gute Haltbarkeit und somit eine lange Lebensdauer. Darüber hinaus sind sie besonders wetterbeständig. Sie können sowohl für Neukonstruktionen als auch bei Renovierungen von Altgebäuden eingesetzt werden. Die Verbundmaterialien können meist in einfacher Weise zugeschnitten werden und auch variabel in ihrer Größe dimensioniert werden. Da sich die Dicke einer Verbundplatte, die eine entsprechende Solarfolie trägt, von einer Verbundplatte ohne Solarfolie nur unwesentlich unterscheidet, können die entsprechenden Platten an einer Fassade ohne weiteres auch miteinander kombiniert werden, ohne das besondere bauliche Änderungen zusätzlich vorgesehen werden müssten.

Als Verbundmaterial kann insbesondere bei einem Ausführungsbeispiel der Erfindung ein Verbundmaterial aus wenigstens zwei aufeinander laminierten Schichten bestehen. Eine dieser Schichten, welche unmittelbar mit der Dünnschichtsolarzelle in Verbindung steht, kann aus einem Material, beispielsweise einem Metall gewählt werden, dass entsprechend eine gute Wärmeleitfähigkeit besitzt.

Beispielsweise kann bei einer Ausführungsform der Erfindung eine Schicht aus einem isolierenden Material, beispielsweise Polyethylen oder Polypropylen ausgebildet sein, während als Metallschicht z. B. eine Aluminiumschicht gewählt wird. Ferner kommen auch Schichten aus einem mineralischen Füllstoff mit polymeren Bindemitteln in Betracht. Aluminium zeichnet sich dadurch aus, dass es eine geringe Dichte aufweist und somit besonders leicht ist. Es ist witterungsbeständig und darüber hinaus gut zu verarbeiten.

Bei einer bevorzugten Ausführungsform der Erfindung wird ein Verbundmaterial mit einer Kernschicht aus Kunststoff, insbesondere Polypropylen oder Polyethylen verwendet, wobei zu beiden Seiten des Verbundmaterials jeweils eine Deckschicht aus Aluminium ausgebildet ist. Ein derartiges Material kann insbesondere sehr dünn gefertigt werden. Als Decklage kann beispielsweise ein Aluminiumblech der Dicke 0,5 mm zur Verfügung gestellt werden. Die Kernschicht aus Kunststoff kann typischerweise eine Dicke von 2 mm - 3 mm betragen, sodass die Gesamtdicke der Verbundplatte beispielsweise kleiner als 5 mm, vorzugsweise 4 mm beträgt. Denkbar ist zudem, dass die entsprechenden Verbundplatten zusätzlich mit einer Lackschicht bedeckt werden. Üblicherweise besitzen derartige Materialien zusätzlich ein für gebäudegünstiges Brandverhalten, dass heißt eine brandhemmende Wirkung.

Als Lackierung kommen beispielsweise Polyesterbeschichtungen (typische Dicke etwa 5 Mikrometer) in Frage. Ein derartiges Material zeichnet sich insbesondere durch eine schlechte Brennbarkeit aus bzw. ist sogar nicht brennbar. Zudem besitzen derartige Platten den Vorteil, dass sie in der Regel biegesteif sind. Sie verfügen über gute Isoliereigenschaften und sind auch schall- oder schwingungsdämpfend. Des Weiteren können die Materialien so gewählt werden, dass diese recyclebar und umweltfreundlich sind. Hinsichtlich ihrer Verarbeitung können kleinformatige, aber auch großformatige Platten hergestellt werden.

Bei einer besonders bevorzugten Weiterbildung der Erfindung ist die Dünnschichtsolarzelle als Solarfolie, insbesondere als sogenannte CIGS-Solarfolie ausgebildet. Die Abkürzung CIGS steht für Cu (In, Ga) (S, Se)₂, also Kupfer(Indium, Gallium) (Schwefel, Selen)₂. Es handelt sich dabei um die entsprechenden Halbleitermaterialien, die zum Aufbau der Solarfolie benötigt werden.

Die CIGS-Schicht ist in der Regel nur wenige Mikrometer dick, während bei Dickschicht-Solarzellen auf Grundlage eines Bulk-Siliziummaterials in der Regel mindestens die 50fache Dicke besitzt. Die Dünnschicht-Solarfolien können so ausgebildet werden, dass sie nicht nur leicht, sondern auch besonders flexibel sind, was insbesondere durch die Wahl des entsprechenden Substrates beeinflusst wird. Auch wenn derartige Solarfolien im Wirkungsgrad teilweise unter dem von Dickschicht-Solarzellen liegen, besitzen sie insbesondere den Vorteil, dass sie in der Regel kostengünstig sind, und, gerade im Zusammenhang mit der vorliegenden Erfindung, auch auf Fassaden großflächig an einem Gebäude angebracht werden können, sodass insgesamt die Energieausbeute noch günstiger ausfällt als bei einer entsprechenden Anbringung von Dickschicht-Solarzellen. Beispielsweise kann bei flexiblen Folien eine Metallfolie oder ein Polyimid-Substrat dienen. Im Vergleich zu Dickschichtsolarzellen zeichnen sich derartige Solarfolien durch eine besondere Umweltfreundlichkeit aus. Dementsprechend sind also Ausführungsformen der Erfindung denkbar, bei denen eine flexible CIGS-Solarfolie verwendet wird, beispielsweise mit einem Metallsubstrat oder einem Polymersubstrat.

Denkbar ist darüber hinaus, dass die Grundplatte des Konstruktionselements selbst als Substrat für die Dünnschicht-Solarzelle ausgebildet ist und die Schichten der Dünnschichtsolarzelle unmittelbar auf die Grundplatte aufgebracht werden. Es besteht ferner die Möglichkeit, dass das sonst bei Solarfolien verwendete Substrat, etwa eine Metallfolie oder Polymerfolie, dennoch zwischen Grundplatte und der eigentlichen Halbleiterschicht aufgebracht wird.

Bei einem entsprechenden Herstellungsverfahren zur Herstellung eines Konstruktionselementes gemäß der Erfindung wird also zum einen die Grundplatte aus dem Verbundmaterial hergestellt und auf einer Seite einer Deckschicht eine Dünnschichtsolarzelle bzw. eine Solarfolie ausgebildet.

Denkbar sind insbesondere zwei Ausführungsformen des Herstellungsverfahrens für ein Konstruktionselement gemäß der Erfindung, nämlich zum einen, dass eine vorgefertigte Verbundplatte verwendet wird, die sodann mit einer Solarfolie beklebt wird. Einige der Solarzellen sind bereits mit einer Klebeschicht ausgebildet, sodass diese auf einer Oberfläche aufgeklebt werden können. Ein derartiges Herstellungsverfahren erhöht insbesondere die Flexibilität, da zunächst einmal die gewünschte Menge an Solarfolie bereit gestellt werden kann und zusätzlich die Verbundplatten flexibel eingesetzt werden können. Bei Bedarf kann die Verbundplatte entsprechend mit Solarfolie beklebt werden. Des Weiteren ist auch ein Austausch der Solarfolie in vorteilhafter Weise möglich. Gegebenenfalls lässt sich ein Bekleben der Verbundplatte auch bei der Gestaltung einer entsprechenden Fassade vor Ort realisieren.

Zum anderen ist denkbar, dass bei der Herstellung der Verbundplatte die Schichten der Solarfolie unmittelbar auf der Deckschicht abgeschieden werden, sodass gewissermaßen eine Baueinheit aus Verbundplatte zusammen mit der Solarfolie entsteht. Je nach Herstellungsverfahren kann entweder zunächst die Verbundplatte gefertigt werden, während die Solarfolie anschließend auf der Deckschicht aufgebracht wird. Zudem ist grundsätzlich denkbar, dass die Deckschicht mit einer entsprechender. Dünnschicht-Solarzelle aufgebaut wird und anschließend die Deckschicht mit dem restlichen Schichtaufbau der Verbundplatte versehen wird. Die Schichten der Verbundplatte werden üblicherweise aufeinander laminiert. Auch dann, wenn die Dünnschicht-Solarzelle unmittelbar auf der Verbundplatte ausgebildet wird, ist insbesondere ein einfacher und kostengünstiger Austausch eines solchen Konstruktionselementes möglich.

Zudem besteht grundsätzlich die Möglichkeit, dass ein entsprechendes Konstruktionselement mit einer Solarfolie auch einfach, ohne bauliche Änderungen, gegen eine Verbundplatte ohne Solarfolie ausgetauscht wird.

Dementsprechend zeichnet sich ein Gebäude mit wenigstens einem Gebäudeteil, insbesondere einer Fassade oder einem Dach als Gebäudeteil dadurch aus, dass der Gebäudeteil wenigstens teilweise mit wenigstens einem Konstruktionselement gemäß der Erfindung bzw. einer Ausführungsform der Erfindung verkleidet ist. Durch diese Maßnahme kann nicht nur eine dekorative Verkleidung ermöglicht werden, sondern flexibel und Kostengünstig ein Beitrag zur Energiegewinnung geleistet werden. Die Konstruktionselemente gemäß der Erfindung sind vergleichsweise kostengünstig und verstehen sich nicht nur als Alternative zur Anbringung herkömmlicher Solarzellen sondern nutzen auch die günstigen Eigenschaften der Verkleidung mittels neuartiger Verbundmaterialien.

Bei einer vorteilhaften Ausführungsform der Erfindung kann das Gebäude insbesondere als Solartankstelle ausgebildet sein. In der Fahrzeugtechnik gewinnen Elektroautos immer mehr an Bedeutung. Um eine Versorgung mit elektrischer Energie in ausreichendem Maße gewährleisten zu können, gewinnen alternative Energien immer mehr an Bedeutung. Gerade auch auf Solarenergie kann in diesem Zusammenhang nicht verzichtet werden. Insbesondere Solartankstellen bildet somit eine besonders passende Anwendung für die erfindungsgemäßen Konstruktionselemente und deren Ausführungsformen. Die Solartankstelle kann durch die Erfindung zum einen vergleichsweise günstig hergestellt und betrieben werden, zumindest im Vergleich mit einer Solartankstelle, die aus Dickschicht-Solarzellen aufgebaut wird. Zudem kann die Solartankstelle aber auch besonders wirtschaftlich betrieben werden, da eine gute Energiegewinnung durch diese selbst ermöglicht wird.

Außerdem wird die Verwendung eines entsprechenden Konstruktionselementes gemäß der Erfindung bzw. einer entsprechenden Ausführungsform der Erfindung zur Erzeugung von elektrischer Energie für eine Solartankstelle beansprucht.

### Ausführungsbeispiel:

Ausführungsbeispiele der Erfindung sind in den Zeichnungen dargestellt und werden nachstehend unter Angabe weiterer Einzelheiten und Vorteile näher erläutert. Im Einzelnen zeigen
- Figur 1: eine schematische Darstellung des Aufbaus eines Konstruktionselementes gemäß der Erfindung,
- Figur 2: eine mit Konstruktionselemente gemäß der Erfindung verkleidete Fassadenwand, sowie
- Figur 3: eine Solartankstelle gemäß der Erfindung.

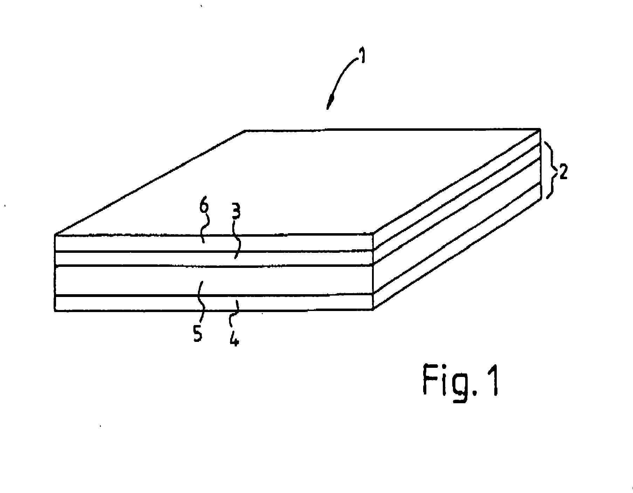

Figur 1 zeigt eine schematische Darstellung des Schichtaufbaus eines Konstruktionselements 1 gemäß der Erfindung. Das Konstruktionselement 1 umfasst eine Verbundplatte 2, welche als dreischichtiges Laminat ausgebildet ist, nämlich mit zwei Deckschichten 3, 4 aus Aluminium sowie einer Kernschicht 5 aus Polyethylen. Die Kernschicht 5 ist mit den Deckschichten 3 und 4 verleimt. Auf der Deckschicht 3 ist eine Solarfolie 6 angebracht. Im vorliegenden Ausführungsbeispiel gemäß Figur 1 ist die Solarfolie auf die Deckschicht 3 aufgeklebt. Das Konstruktionselement 1 wird dabei so gefertigt, dass zunächst eine Verbundplatte 2 hergestellt wird, welche wiederum durch Laminieren der Deckschichten 3, 4 auf der Kernschicht 5 gebildet wird. Anschließend wird auf die Deckschicht 3 die Solarfolie 6 aufgeklebt. Bei der Solarfolie 6 handelt es sich um eine CIGS-Folie, die ein Substrat besitzt, welches der Solarfolie 6 flexible Eigenschaften verleiht.

Entsprechende Verbundplatten für ein Konstruktionselement gemäß der Erfindung können regelmäßig in einfacher Weise bearbeitet werden. Sie lassen sich in der Regel in einfacher Weise durchbohren können durch Fräsen bearbeitet werden und können somit verschraubt oder vernietet werden. Auch Schweißen mit Heißluft ist möglich. Zudem kann Verbundplatte auch praktisch beliebig beklebt bzw. laminiert werden. Darüber hinaus ist die Aufbringung von Farben im Siebdruckverfahren oder durch Bemahlen möglich.

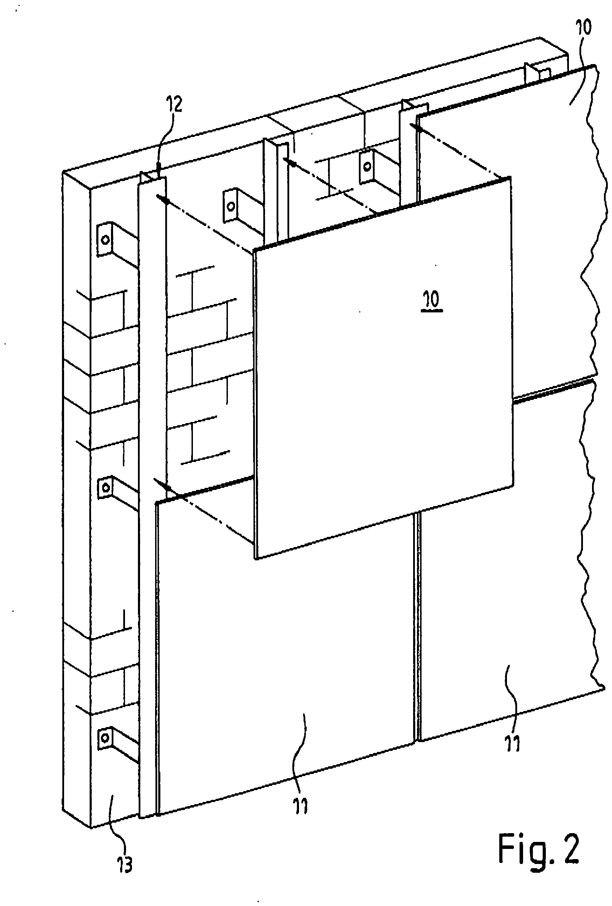

Figur 2 zeigt eine typische Anbringung der Konstruktionselemente gemäß der Erfindung einer Fassade 13. Die Konstruktionselemente 10, 11 werden dabei an eine Befestigungsvorrichtung 12 angebracht, die wiederum an die Fassade bzw. wand 13 geschraubt wird, sodass die Konstruktionselemente 10, 11 zur Wand 13 beabstandet sind. Die Konstruktionselemente 10, 11 können z. B. an eine Schiene der Befestigungsvorrichtung geschraubt, genietet oder geklebt werden. Die Konstruktionselemente 10 und 11 umfassen beide die gleichen Verbundplatten, allerdings sind die Konstruktionselemente 11 zusätzlich mit einer Solarfolie ausgestattet, dass heißt es handelt es bei den Konstruktionselementen 11 um Konstruktionselemente gemäß der Erfindung.

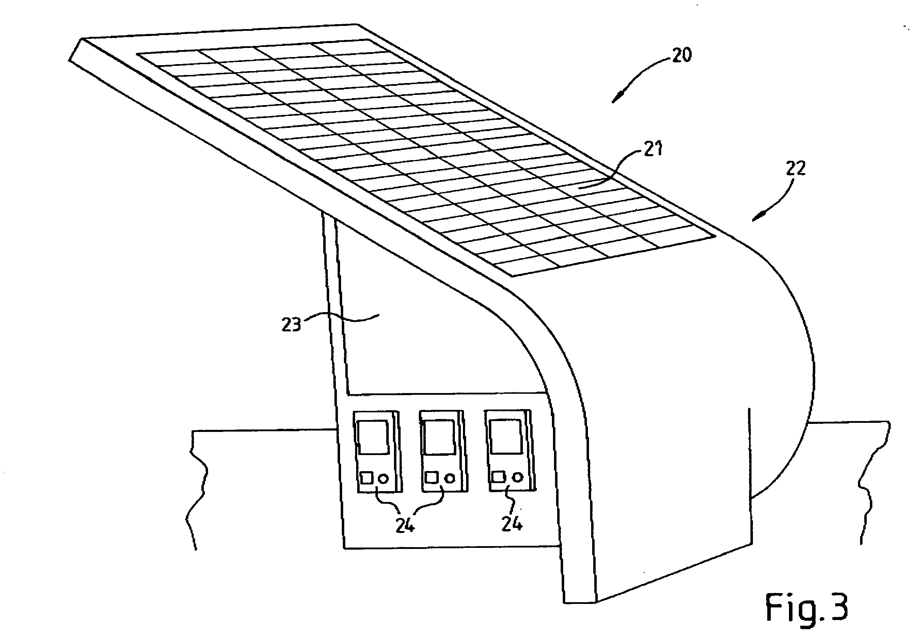

In Figur 3 ist ein Gebäude 20 gemäß der Erfindung dargestellt, welches als Solartankstelle ausgebildet ist. Eine Solartankstelle 20 dient dazu, Elektrofahrzeuge wieder aufzuladen, wobei die elektrische Energie dazu mittels Sonnenenergie gewonnen wird. Im vorliegenden Fall wird die elektrische Energie über Konstuktionselemente 21 mit Solarfolie gewonnen. Diese sind auf einem segelartigen Dach 22 angebracht. Zudem umfasst die Solartankstelle 20 ein Kabinenhaus 23, in welchem die Tankstellenkunden beim Tankwart bezahlen können. Des Weiteren befinden sich am Tankstellenhaus 23 Anschlüsse 24 zum Aufladen der Elektrofahrzeuge. Gerade bei der vorliegenden Anwendung, bei der es auf eine möglichst einfache und leichte Bauweise ankommt, können die Konstruktionselemente 21 gemäß der Erfindung besonders vorteilhaft eingesetzt werden. Zudem handelt es sich um eine vergleichsweise kostengünstige Bauweise, wodurch der Strom in der Solartankstelle vergleichsweise kostengünstig angeboten werden kann.

### Bezugszeichenliste:

- 1: Konstruktionselement
- 2: Verbundplatte
- 3: Deckschicht aus Aluminium
- 4: Deckschicht aus Aluminium
- 5: Kern
- 6: Solarfolie
- 10: Konstruktionsverbundplatte
- 11: Konstruktionselement mit Solarfolie
- 12: Befestigungsvorrichtung
- 13: Fassade/Wand
- 20: Solartankstelle
- 21: Konstruktionselement mit Sclarfolie
- 22: segelförmiges Dach
- 23: Tankstellenhaus
- 24: Anschlüsse

## Patentansprüche

**1.** Konstruktionselement (1, 11, 21) für Gebäudefassaden (13), insbesondere für die Außenwandverkleidung von Fassaden, das eine Grundplatte (2) aus einem Verbundmaterial umfasst, wobei an wenigstens einer Seite der Grundplatte eine Dünnschicht-Solarzelle (6) zur Erzeugung von elektrischer Energie angeordnet ist.

**2.** Konstruktionselement nach einem der vorgenannten Ansprüche, **dadurch gekennzeichnet, dass** das Verbundmaterial aus wenigstens zwei aufeinander laminierten Schichten (3, 4, 5) besteht.

**3.** Konstruktionselement nach einem der vorgenannten Ansprüche, **dadurch gekennzeichnet, dass** eine der Schichten aus Kunststoff, insbesondere aus Polyethylen oder Polypropylen, oder aus einem mineralischen Füllstoff mit polymeren Bindemitteln ausgebildet ist.

**4.** Konstruktionselement nach einem der vorgenannten Ansprüche, **dadurch gekennzeichnet, dass** wenigstens eine der Schichten aus Metall gefertigt ist, insbesondere aus Aluminium.

**5.** Konstruktionselement nach einem der vorgenannten Ansprüche, **dadurch gekennzeichnet, dass** das Verbundmaterial eine Kernschicht (5) aus Kunststoff und zu beiden Seiten jeweils eine Deckschicht (3, 4) aus Aluminium umfasst.

**6.** Konstruktionselement nach einem der vorgenannten Ansprüche, **dadurch gekennzeichnet, dass** die Dünnschicht-Solarzelle als Solarfolie ausgebildet ist, insbesondere eine CIGS-Solarfolie.

**7.** Konstruktionselement nach einem der vorgenannten Ansprüche, **dadurch gekennzeichnet, dass** die Solarfolie als flexible CIGS-Solarfolie, insbesondere mit einem Metallsubstrat oder mit einem Polymersubstrat, ausgebildet ist.

**8.** Konstruktionselement nach einem der vorgenannten Ansprüche, **dadurch gekennzeichnet, dass** die Grundplatte als Substrat der Dünnschicht-Solarzelle ausgebildet ist und die Schichten der Dünnschicht-Solarzelle unmittelbar auf die Grundplatte aufgebracht sind.

**8.** Verfahren zur Herstellung eines Konstruktionselementes, welches die Herstellung einer Grundplatte aus einem Verbundmaterial mit wenigstens einer Deckschicht umfasst, **dadurch gekennzeichnet, dass** eine Dünnschicht-Solarzelle, die als Solarfolie ausgebildet ist, auf einer Seite der Deckschicht angebracht wird.

**9.** Verfahren zur Herstellung eines Konstruktionselementes nach einem der vorgenannten Ansprüche, **dadurch gekennzeichnet, dass** die Solarfolie auf die Deckschicht geklebt wird.

**10.** Verfahren zur Herstellung eines Konstruktionselementes nach einem der vorgenannten Ansprüche, **dadurch gekennzeichnet, dass** die Herstellung des Verbundmaterials vor der Anbringung der Solarfolie erfolgt.

**11.** Verfahren zur Herstellung eines Konstruktionselementes, nach einem der vorgenannten Ansprüche, **dadurch gekennzeichnet, dass** die Schichten der Dünnschicht-Solarzelle auf der Deckschicht abgeschieden werden.

**12.** Gebäude (20) mit wenigstens einem Gebäudeteil, insbesondere einer Fassade oder einem Dach, **dadurch gekennzeichnet, dass** das Gebäudeteil wenigstens teilweise mit
wenigstens einem Konstruktionselement nach einem der vorgenannten Ansprüche verkleidet ist.

**13.** Gebäude nach einem der vorgenannten Ansprüche, **dadurch gekennzeichnet, dass** das Gebäude als Solartankstelle (20) ausgebildet ist und das wenigstens eine Konstruktionselement (21) als zur Bereitstellung von elektrischer Energie ausgebildet ist.

**14.** Verwendung eines Konstruktionselementes (21) nach einem der vorgenannten Ansprüche zur Erzeugung elektrischer Energie für eine Solartankstelle (20).
